# EUROPEAN PATENT APPLICATION

(11) **EP 4 492 530 A1**
(43) Date of publication of application: **15.01.2025**
(21) Application number: 24186663.1
(22) Date of filing: 04.07.2024
(51) Int. Cl.: H01M 10/42, H01M 50/287, H02J 7/00, H01M 10/04

(54) **BATTERY PACK AND METHOD OF MANUFACTURING THE SAME**

(30) Priority: 10.07.2023 KR 20230089089
(71) Applicant: SAMSUNG SDI CO., LTD., Giheung-gu Yongin-si, Gyeonggi-do 17084 (KR)
(72) Inventor: LEE, Seokbong, Yongin-si (KR)
(74) Representative: Marks & Clerk LLP

(57) **Abstract**

A battery pack (10) includes a case (120), a battery cell (110) accommodated in the case (120), and a protection circuit module (130) connected to the battery cell (110), wherein the protection circuit module (130) includes a substrate (131), at least one component mounting area (134) on the substrate (131) and comprising a plurality of components (1341), and at least one coating area (133) on the substrate (131) at least in part corresponding to the at least one component mounting area (134) and comprising at least one protruding portion (1331) supporting a coating solution (C) within the at least one coating area (133), and at least a portion of the at least one protruding portion (1331) includes a same material as that of the substrate (131) and is mounted on the substrate (131).

## Description

### FIELD

One or more embodiments relate to a battery pack and a method of manufacturing the same.

### BACKGROUND

Secondary batteries refer to batteries that are chargeable and dischargeable, unlike non-rechargeable primary batteries. Secondary batteries are used as energy sources for mobile devices, electric vehicles, hybrid vehicles, electric bicycles, uninterruptible power supplies, etc. Depending on the type of an external device to which the secondary battery is applied, a secondary battery may be used in the form of a single battery or in the form of a pack in which multiple batteries are connected to each other and bundled in one unit.

The above-described background art is technical information that the inventor possessed to derive the present disclosure or acquired during the derivation process of the present disclosure, and is not necessarily known art disclosed to the general public prior to filing the present disclosure.

### SUMMARY

One or more embodiments include a battery pack and a method of manufacturing the same, in which a coating solution is applied to a coating area of a protection circuit module at a constant height, thereby preventing contamination of the protection circuit module and managing a shape and height of the protection circuit module.

One or more embodiments include a battery pack and a method of manufacturing the same, in which a fixing frame for holding a coating solution is mounted on a substrate, thereby easily forming a shape and height of the coating solution.

Additional aspects will be set forth in part in the description which follows and, in part, will be apparent from the description, or may be learned by practice of the presented embodiments of the present disclosure.

According to one or more embodiments, a battery pack includes a case, a battery cell accommodated in the case, and a protection circuit module connected to the battery cell, wherein the protection circuit module includes a substrate, at least one component mounting area on the substrate and comprising a plurality of components, and at least one coating area on the substrate corresponding to at least a portion of (e.g. corresponding at least in part to) the at least one component mounting area and comprising at least one protruding portion supporting a coating solution within the at least one coating area, and at least a portion of the at least one protruding portion includes a same material as that of the substrate and is mounted on the substrate.

The substrate may include at least one first mounting area corresponding to the at least one component mounting area and having a solder pad formed thereon, and at least one second mounting area corresponding to the at least one coating area and having a solder pad formed thereon.

Each of the at least one coating area may include a single protruding portion including a single piece.

The single protruding portion may be provided outside each of the at least one coating area and may have a closed contour.

An inner edge of the single protruding portion may be separated from an edge of each of the at least one coating area, and an outer edge of the single protruding portion may be separated from an edge of the substrate.

The at least one protruding portion may have a constant height.

A height of the at least one protruding portion may gradually increase toward a central portion of the at least one protruding portion in a length direction thereof.

The at least one protruding portion may comprise a plurality of protruding portions provided for each of the at least one component mounting area and the plurality of protruding portions may be separated from each other to form a plurality of gaps.

The plurality of protruding portions may comprise two protruding portions provided for each of the at least one component mounting area and respective ones of the two protruding portions being disposed on a respective one of a first side and a second side of the at least one component mounting area in a length direction of the substrate, and a gap between the two protruding portions may face a width direction of the substrate.

Some protruding portions of the plurality of protruding portions may be provided to be separated from each other and correspond to a long side of the at least one component mounting area, and one protruding portion of the plurality of protruding portions may be provided to correspond to a short side of the at least one component mounting area.

The at least one component mounting area may comprise a plurality of component mounting areas disposed along a length direction of the substrate, and the at least one coating area may correspond to a component mounting area of the plurality of component mounting areas disposed in a central portion of the substrate in the length direction thereof.

According to one or more embodiments, a method of manufacturing a battery pack includes forming at least one first mounting area and at least one second mounting area by forming solder pads on a substrate, forming at least one component mounting area by mounting a plurality of components in the at least one first mounting area, forming at least one coating area by mounting at least one protruding portion in the at least one second mounting area, and applying a coating solution to the at least one coating area.

The forming of the at least one first mounting area and the at least one second mounting area may include forming the solder pads on the substrate such that the at least one second mounting area surrounds the at least one first mounting area.

The forming of the at least one coating area may include mounting a single protruding portion including a single piece in each of the at least one second mounting area.

The forming of the at least one coating area may include mounting a plurality of protruding portions in each of the at least one second mounting area such that a respective gap is formed between respective ones of the plurality of protruding portions.

According to some embodiments, there is provided a protection circuit module configured to be connected to a battery cell, the protection circuit module comprising: a substrate; at least one component mounting area on the substrate and comprising a plurality of components; and at least one coating area on the substrate at least in part corresponding to the at least one component mounting area and comprising at least one protruding portion supporting a coating solution within the at least one coating area, and at least a portion of the at least one protruding portion comprises a same material as that of the substrate and is mounted on the substrate.

In some embodiments, the substrate may include at least one first mounting area corresponding to the at least one component mounting area and having a solder pad formed thereon; and at least one second mounting area corresponding to the at least one coating area and having a solder pad formed thereon.

In some embodiments each of the at least one coating area may include a single protruding portion comprising a single piece.

In some embodiments, the single protruding portion may be provided outside each of the at least one coating area and may have a closed contour.

In some embodiments, an inner edge of the single protruding portion may be separated from an edge of each of the at least one coating area, and an outer edge of the single protruding portion is separated from an edge of the substrate.

At least some of the above and other features of the invention are set out in the claims.

### BRIEF DESCRIPTION OF THE DRAWINGS

The above and other aspects, features, and advantages of certain embodiments of the present disclosure will be more apparent from the following description taken in conjunction with the accompanying drawings, in which:
FIG. 1 shows a state where a battery cell and a case are being coupled to each other;
FIG. 2 shows an assembled state of a battery cell and a case;
FIG. 3 schematically shows a battery cell and a protection circuit module of a battery pack;
FIG. 4 shows an enlarged view of a portion of a protection circuit module;
FIG. 5 shows a cross-section taken along line A-A' of FIG. 4;
FIGS. 6A and 6B each show a cross section taken along line B-B' of FIG. 4;
FIG. 7 shows an enlarged view of a portion of a protection circuit module;
FIG. 8 shows an enlarged view of a portion of a protection circuit module; and
FIGS. 9, 10, 11 and 12 show a method of manufacturing a battery pack.

### DETAILED DESCRIPTION

Reference will now be made in detail to embodiments, examples of which are illustrated in the accompanying drawings, wherein like reference numerals refer to the like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

Aspects of some embodiments of the present disclosure and methods of accomplishing the same may be understood more readily by reference to the detailed description of embodiments and the accompanying drawings. Hereinafter, embodiments will be described in more detail with reference to the accompanying drawings. The described embodiments, however, may have various modifications and may be embodied in different forms, and should not be construed as being limited to only the illustrated embodiments herein. Further, each of the features of the various embodiments of the present disclosure may be combined with each other, in part or in whole, and technically various interlocking and driving are possible. Each embodiment may be implemented independently of each other or may be implemented together in an association. The described embodiments are provided as examples so that this disclosure will be thorough and complete, and will fully convey the aspects of the present disclosure to those skilled in the art, and it should be understood that the present disclosure covers all the modifications, equivalents, and replacements within the idea and technical scope of the present disclosure. Accordingly, processes, elements, and techniques that are not necessary to those having ordinary skill in the art for a complete understanding of the aspects of the present disclosure may not be described.

Unless otherwise noted, like reference numerals, characters, or combinations thereof denote like elements throughout the attached drawings and the written description, and thus, descriptions thereof will not be repeated. Further, parts that are not related to, or that are irrelevant to, the description of the embodiments might not be shown to make the description clear.

In the drawings, the relative sizes of elements, layers, and regions may be exaggerated for clarity. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result, for example, of manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the illustrated shapes of regions, but are to include deviations in shapes that result from, for instance, manufacturing.

For example, an implanted region illustrated as a rectangle may have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Thus, the regions illustrated in the drawings are schematic in nature and their shapes are not intended to illustrate the actual shape of a region of a device and are not intended to be limiting. Additionally, as those skilled in the art would realize, the described embodiments may be modified in various ways, all without departing from the scope of the present disclosure.

In the detailed description, for the purposes of explanation, numerous specific details are set forth to provide a thorough understanding of various embodiments. It is apparent, however, that various embodiments may be practiced without these specific details or with one or more equivalent arrangements. In other instances, well-known structures and devices are shown in block diagram form to avoid unnecessarily obscuring various embodiments.

Spatially relative terms, such as "beneath," "below," "lower," "lower side," "under," "above," "upper," "upper side," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component is referred to as being "formed on," "on," "connected to," or "(operatively or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or intervening layers, regions, or components may be present. However, "directly connected/directly coupled," or "directly on," refers to one component directly connecting or coupling another component, or being on another component, without an intermediate component. In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components such as "between," "immediately between" or "adjacent to" and "directly adjacent to" may be construed similarly. In addition, it will also be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XYY, YZ, and ZZ, or any variation thereof. Similarly, the expression such as "at least one of A and B" and "at least one of A or B" may include A, B, or A and B. As used herein, "or" generally means "and/or," and the term "and/or" includes any and all combinations of one or more of the associated listed items. For example, the expression such as "A and/or B" may include A, B, or A and B. Similarly, expressions such as "at least one of," "a plurality of," "one of," and other prepositional phrases, when preceding a list of elements, modify the entire list of elements and do not modify the individual elements of the list.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

The terminology used herein is for the purpose of describing particular embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

When one or more embodiments may be implemented differently, a specific process order may be performed differently from the described order. For example, two consecutively described processes may be performed substantially at the same time or performed in an order opposite to the described order.

As used herein, the term "substantially," "about," "approximately," and similar terms are used as terms of approximation and not as terms of degree, and are intended to account for the inherent deviations in measured or calculated values that would be recognized by those of ordinary skill in the art. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30 %, 20 %, 10 %, 5 % of the stated value. Further, the use of "may" when describing embodiments of the present disclosure refers to "one or more embodiments of the present disclosure."

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

Increased computing performance of processors included in electronic devices and increased output of electric vehicles have naturally led to increased capacity of secondary batteries. The design of secondary batteries needs to take user convenience into consideration and secure a desired output within a limited space. Thus, an overcharge blocking voltage of secondary batteries has gradually increased and an overdischarge blocking voltage thereof has gradually decreased, thus expanding the usable area of battery packs to which secondary batteries are applied.

For this reason, a battery pack includes a protection circuit module to prevent overcharge, overdischarge, overcurrent, short circuit, etc. of a battery cell during use. The protection circuit module performs an overcharge protection function to prevent the battery cell from being overcharged beyond a protection voltage so that swelling and explosion of the battery do not occur due to gas and heat generated from the battery cell, an overdischarge protection function to prevent the battery cell from being discharged below an appropriate voltage, resulting in damage to the battery cell, an overcurrent blocking function to prevent the battery cell or the protection circuit module from being damaged due to malfunction of an external device, accidental overcurrent, etc., and a short circuit protection function to prevent the battery cell or the protection circuit module from being damaged due to a short circuit in an external load.

The protection circuit module includes various components mounted on a substrate. In the protection circuit module, a coating solution is applied onto the components to insulate the components from each other and protect the components from being damaged due to an impact, etc. occurring during use. However, if the coating solution is applied directly onto the components without a separate guide, the coating solution may overflow not only into a coating area in which the components are arranged, but also into adjacent areas. For example, the coating solution may contaminate a substrate tab that connects the protection circuit module to the battery cell, and thus, it may be impossible to weld the protection circuit module and the battery cell to each other. For example, it may be difficult to form the protection circuit module to a desired height and shape because there is no guide to maintain the shape and height of the coating solution constant.

Recently, there has been a demand to make the substrate of the protection circuit module thin to reduce the size of the battery pack. However, as the thickness of the substrate decreases, the substrate may be easily damaged even by a small impact.

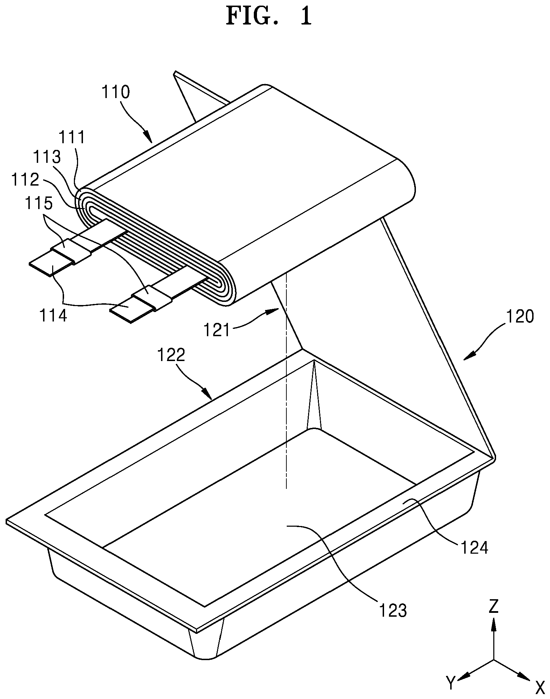

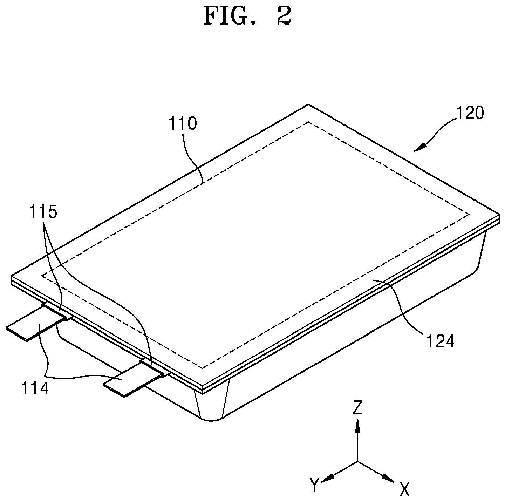

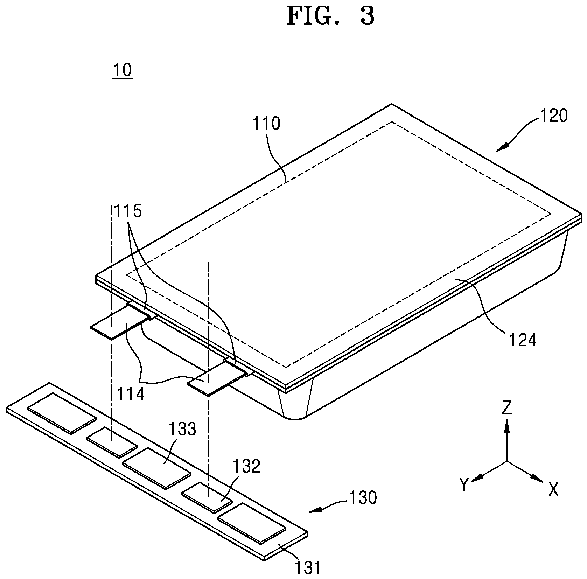

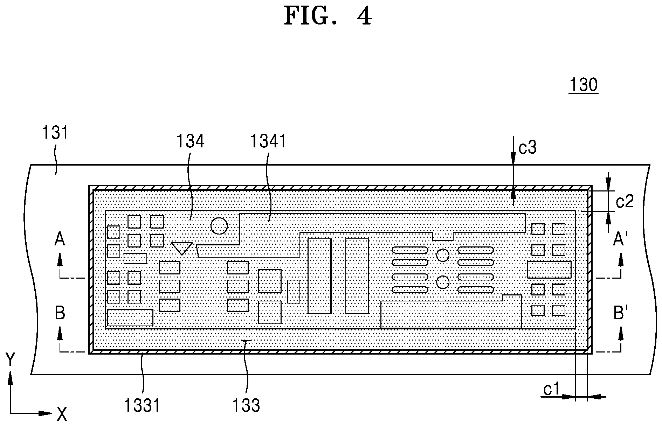

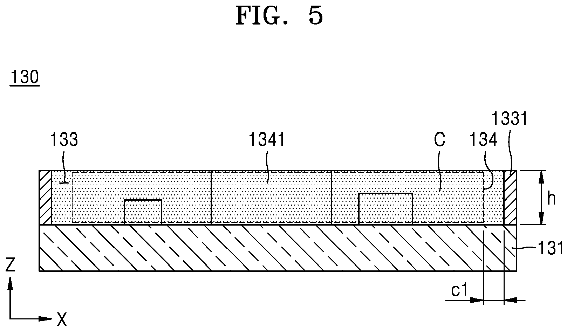

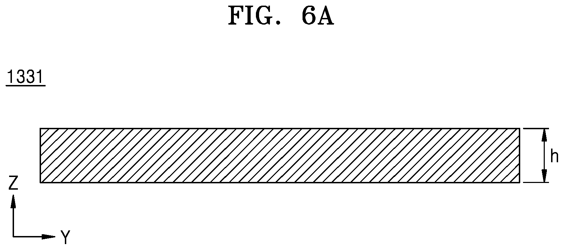

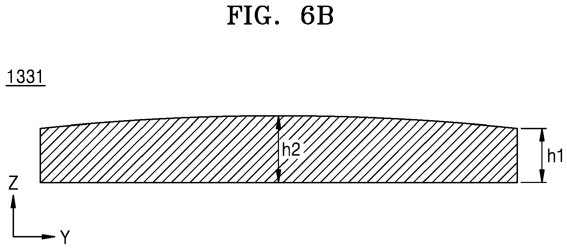

FIG. 1 shows a state where a battery cell 110 and a case 120 are being coupled to each other, FIG. 2 shows an assembled state of the battery cell 110 and the case 120, FIG. 3 schematically shows the battery cell 110 and a protection circuit module 130 of a battery pack 10, FIG. 4 shows an enlarged view of a portion of the protection circuit module 130, FIG. 5 shows a cross-section taken along line A-A' of FIG. 4, and FIGS. 6A and 6B each show a cross section taken along line B-B' of FIG. 4.

The battery pack 10 according to embodiments of the present disclosure may be a pouch-type secondary battery and may be used in devices such as a desktop personal computer (PC), a tablet PC, a smartphone, a laptop PC, etc. In some embodiments, the battery pack 10 may be a can-type or cylindrical secondary battery and may be used in devices such as a tablet PC, a smartphone, a vehicle battery, etc. Hereinafter, for convenience of description, a case where the battery pack 10 is of a pouch type is described.

The battery pack 10 includes the case 120, the battery cell 110 accommodated in the case 120, and the protection circuit module 130 connected to the battery cell 110.

For example, the battery pack 10 includes the case 120, the battery cell 110 accommodated in the case 120, and the protection circuit module 130 connected to the battery cell 110, wherein the protection circuit module 130 includes a substrate 131, at least one component mounting area 134 on the substrate 131 and including a plurality of components 1341, and at least one coating area 133 on the substrate 131 to correspond to the at least one component mounting area 134 and including at least one protruding portion 1331 supporting a coating solution C therein, and at least a portion of the at least one protruding portion 1331 includes the same material as that of the substrate 131 and is mounted on the substrate 131.

The battery cell 110 may be manufactured in the form of a jelly roll by winding a separator 113 between a first electrode plate 111 and a second electrode plate 112. In some embodiments, the battery cell 110 may be manufactured in the form of a stack by stacking separators 113 between a plurality of first electrode plates 111 and a plurality of second electrode plates 112. In some embodiments, the battery cell 110 may be manufactured in the form of both a jelly roll and a stack.

The first electrode plate 111 may include a first active material coating portion formed by intermittently coating a first active material, which is a conductive material in the form of a sheet, onto a first substrate, and a first uncoated portion in which the first substrate is exposed because the first active material is not coated thereon. For example, the first electrode plate 111 may be a negative electrode plate, and the first active material may be a negative electrode active material including a carbon material, such as crystalline carbon, amorphous carbon, carbon composite, carbon fiber, etc., a lithium metal, or a lithium alloy.

The second electrode plate 112 may have a polarity different from that of the first electrode plate 111 and may include a second active material coating portion formed by intermittently coating a second active material, which is a conductive material in the form of a sheet, onto a second substrate, and a second uncoated portion in which the second substrate is exposed because the second active material is not coated thereon. For example, the second electrode plate 112 may be a positive electrode plate, and the second active material may include a positive electrode active material including lithium, such as LiCoO₂, LiNiO₂, LiMnO₂, LiMn₂O₄, LiNi_{1-x-y}CoₓM_{y}O₂ (where M is a metal), LiFePO₄ (LFP), etc.

The separator 113 may be between the first electrode plate 111 and the second electrode plate 112. The separator 113 may insulate the first electrode plate 111 from the second electrode plate 112 and may exchange lithium ions between the first electrode plate 111 and the second electrode plate 112. The separator 113 may have a length sufficient to completely insulate the first electrode plate 111 from the second electrode plate 112 even if the battery cell 110 contracts or expands in a process of charging/discharging the battery pack 10.

At least one electrode tab 114 may be on a first side of the battery cell 110. For example, two electrode tabs 114 may respectively correspond to the first electrode plate 111 and the second electrode plate 112 and may respectively be on the first electrode plate 111 and the second electrode plate 112 to protrude to the first side of the battery cell 110. The electrode tab 114 may be electrically connected to a first side of the first uncoated portion of the first electrode plate 111 and may extend toward the outside of the battery cell 110. In some embodiments, the electrode tab 114 may be electrically connected to a first side of the second uncoated portion of the second electrode plate 112 and may extend toward the outside of the battery cell 110.

A film portion 115 may be disposed on the electrode tab 114. The film portion 115 may be disposed on one surface of the electrode tab 114 or may surround the electrode tab 114. The film portion 115 may seal the electrode tab 114 exposed to the outside of the battery cell 110. For example, to prevent a short circuit from occurring due to contact of the electrode tab 114 with a metal layer exposed at an end of a sealing portion 124 of the case 120, the film portion 115 may be thermally fused with the sealing portion 124 so that the electrode tab 114 and the sealing portion 124 may be closely coupled to each other.

The case 120 may form the exterior of the battery pack 10 and may accommodate the battery cell 110 therein. The shape and size of the case 120 are not limited, and the case 120 may have a shape and size corresponding to those of the battery cell 110. For example, as shown in FIG. 1, the case 120 may have a hollow cuboid shape. In some embodiments, the case 120 may have a polyhedral shape of another shape or a cylindrical shape.

The case 120 may include a cover 121, a lower case 122, an inner space 123, and the sealing portion 124.

The lower case 122 may include the inner space 123 having a dimension greater than that of the battery cell 110, and the battery cell 110 may be inserted into the inner space 123. The cover 121 may be on an upper surface of the lower case 122 to be openable and closable such that the cover 121 may cover the battery cell 110 in a state where the battery cell 110 is inserted into the inner space 123.

The sealing portion 124 may be provided along an upper edge of the lower case 122. As shown in FIG. 2, in a state where the battery cell 110 is accommodated in the case 120, a portion of the electrode tab 114 may be exposed to the outside of the case 120. The film portion 115 on the electrode tab 114 may be between the cover 121 and the lower case 122 at a position corresponding to the sealing portion 124. As such, the battery cell 110 accommodated in the case 120 may be formed.

The protection circuit module 130 may include an electric circuit and various components for preventing overcharge, overdischarge, overcurrent, and short circuit of the battery cell 110. As shown in FIG. 3, the protection circuit module 130 may be provided outside the case 120 and may be configured to be connected to the electrode tab 114. The protection circuit module 130 may have a plate shape to support two electrode tabs 114.

The protection circuit module 130 includes the substrate 131, at least one component mounting area 134 on the substrate 131 and including a plurality of components 1341, and at least one coating area 133 on the substrate 131 to correspond to the at least one component mounting area 134 and including at least one protruding portion 1331 supporting the coating solution C within the coating area, and at least a portion of the at least one protruding portion 1331 includes the same material as that of the substrate 131 and is mounted on the substrate 131.

As shown in FIG. 3, the substrate 131 may support other components of the protection circuit module 130, may include various electric circuits and components for controlling the battery cell 110, and may be connected to an external control module, etc. in a wired/wireless manner. The substrate 131 may be a printed circuit board (PCB) substrate, for example, a flexible PCB (FPCB) substrate. The substrate 131 may include at least one of FR-1, FR-4, CEM-1, CEM-3, TEFLON, ceramic, and/or metal. The thickness of the substrate 131 may be 2 mm or less. For example, the thickness of the substrate 131 may be 1 mm or less. For example, the substrate 131 may be a thin substrate having a thickness of 0.7 mm or less.

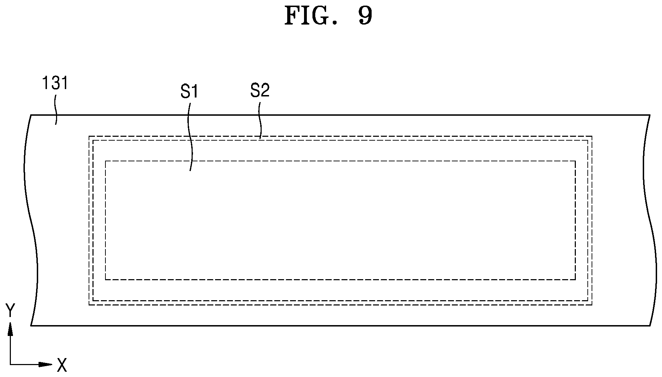

The substrate 131 may include at least one first mounting area S1 (see FIG. 9) and at least one second mounting area S2 (see FIG. 9). The at least one first mounting area S1 may correspond to the at least one component mounting area 134 and may have a solder pad formed therein. The at least one second mounting area S2 may correspond to the at least one coating area 133 and may have a solder pad formed therein.

At least one substrate tab 132 may be on the substrate 131 in the same number as that of the electrode tab 114 (e.g., two, in the illustrated embodiment of FIG. 3) and may be connected to the electrode tab 114 of the battery cell 110. As shown in FIG. 3, two substrate tabs 132 may be separated from each other on an upper surface of the substrate 131. The battery cell 110 and the protection circuit module 130 may be coupled to each other by welding (e.g., by laser welding) the substrate tab 132 and the electrode tab 114 to each other in a state where the substrate tab 132 and the electrode tab 114 are in contact with each other.

The substrate tab 132 may be provided between a plurality of component mounting areas 134 adjacent to each other. For example, the substrate tab 132 may include a metal material, for example, nickel.

The at least one coating area 133 may be an area where components and circuits of the protection circuit module 130 are coated and may correspond to the at least one component mounting area 134. The coating area 133 includes the coating solution C, a film, etc. to insulate electric circuits and components provided in the component mounting area 134 from each other and protect the electric circuits and components from an external impact. Hereinafter, for convenience of description, a case where the coating area 133 is coated with the coating solution C is mainly described. The type of the coating solution C is not limited, as long as the coating solution C may insulate circuits and components from each other and protect the circuits and components from an external impact. The coating solution C may be a high-viscosity material and may be an ultraviolet (UV) coating solution. In some embodiments, the coating solution C may increase the strength of the component mounting area 134.

The coating area 133 may be inside an edge of the substrate 131. As shown in FIG. 4, the coating area 133 may be provided inside the substrate 131 in a length direction of the substrate 131 (an X-axis direction) and a width direction of the substrate 131 (a Y-axis direction). In some embodiments, the coating area 133 may be an area defined inside the protruding portion 1331.

As shown in FIG. 4, the coating area 133 may include the component mounting area 134. The coating area 133 may have an area equal to or greater than that of the component mounting area 134, and the component mounting area 134 may be inside the coating area 133. An inner edge of the coating area 133 may be separated from an outer edge of the component mounting area 134 by a certain gap.

In some embodiments, at least a portion of the coating area 133 may have a height different from that of the upper surface of the substrate 131. For example, at least a portion of the coating area 133 may form a step with the upper surface of the substrate 131, and the coating solution C may be maintained within the coating area 133. For example, the coating solution C may not flow into other areas of the substrate 131 or the substrate tab 132.

Each of the at least one coating area 133 may include at least one protruding portion 1331.

The protrusion portion 1331 may be external to the component mounting area 134 and may surround the component mounting area 134. As shown in FIGS. 4 and 5, the protruding portion 1331 may form a boundary of the coating area 133 along an edge of the coating area 133. The protruding portion 1331 may have a certain width on the upper surface of the substrate 131. In some embodiments, the protruding portion 1331 may protrude by a height h from the upper surface of the substrate 131, and the height h may be appropriately selected considering the amount of the coating solution C and the area of the component mounting area 134. For example, the height h may be about 0.1 mm to about 1 mm, about 0.2 mm to about 0.8 mm, or about 0.3 mm to about 0.7 mm. The height h may be 0.6 mm.

The protruding portion 1331 is mounted on the substrate 131. The protruding portion 1331 may be mounted on the substrate 131 like a component by using a component mounting device. Thus, in mounting components on the substrate 131 to form the protection circuit module 130, the protruding portion 1331 may also be mounted on the substrate 131 so that the coating area 133 may be easily formed. To this end, a solder pad may be formed in advance in an area of the substrate 131 where the protruding portion 1331 is to be mounted, and the protruding portion 1331 may be mounted on the solder pad.

At least a portion of the protruding portion 1331 includes the same material as that of the substrate 131. The protruding portion 1331 may include the same material as that of the substrate 131 and may include at least one of FR-1, FR-4, CEM-1, CEM-3, TEFLON, ceramic, and/or metal. If the protruding portion 1331 includes the same material as that of the substrate 131, the mounting quality of the protruding portion 1331 may be improved.

The protruding portion 1331 may be arranged continuously without interruption. Each of the at least one protruding portion 1331 may include a single piece and may form a closed contour in a plan view. Thus, the coating area 133 may extend continuously without interruption so that even if the coating solution C flows into the coating area 133, the coating solution C may not flow out of the coating area 133. As shown in FIG. 4, the protruding portion 1331 may have a rectangular shape. A component mounting device, etc. may mount one protruding portion 1331 at a position corresponding to one component mounting area 134.

The protruding portion 1331 may be provided outside the coating area 133. An inner edge of the protruding portion 1331 may be separated from an outer edge of the coating area 133, and an outer edge of the protruding portion 1331 may be spaced apart from the edge of the substrate 131.

The outer edge of the protruding portion 1331 may be separated inward from the edge of the substrate 131 by a gap c3 in the width direction of the substrate 131, as shown in FIG. 4, for example. In mounting the protruding portion 1331 on the substrate 131, by preventing a portion of the protruding portion 1331 from deviating to the outside of the substrate 131 due to unavoidable engineering errors, the protruding portion 1331 may be prevented from interfering with the battery pack 10 and other external devices. The gap c3 may be about 0.2 mm to about 0.8 mm. For example, the gap c3 may be about 0.3 mm to about 0.5 mm.

The overall shape and size of the protruding portion 1331 are not limited and may be appropriately selected according to the shape and size of the component mounting area 134. As shown in FIG. 4, if the component mounting area 134 has a rectangular shape, the protruding portion 1331 may similarly include a pair of long sides and a pair of short sides to form a rectangle. For example, the pair of long sides may extend in the length direction of the substrate 131, and the pair of short sides may extend in the width direction of the substrate 131, which crosses the length direction of the substrate 131.

The protruding portion 1331 may have a constant height. As shown in FIG. 6A, the at least one protruding portion 1331 may have a constant height h throughout. Although FIG. 6A shows only a cross-section of a portion corresponding to a long side of one of the at least one protruding portion 1331, the at least one protruding portion 1331 may have the same height h throughout the entirety of the at least one protruding portion 1331.

In other embodiments, the at least one protruding portion 1331 may vary in height. As shown in FIG. 6B, the height of the protruding portion 1331 may gradually increase toward a central portion of the protruding portion 1331. Both ends of the protruding portion 1331 may have a height h1, and the central portion of the protruding portion 1331 may have a height h2 that is greater than the height h1. h1 may be about 60 % to about 90 % or about 70 % to about 80 % of h2. If the central portion of the protruding portion 1331 is formed to have a greater height, the coating solution C having high viscosity may be concentrated in the central portion and prevented from flowing beyond the protruding portion 1331 and into other areas of the substrate 131. The height h2 of the central portion of the protruding portion 1331 may be equal to the maximum height of the protruding portion 1331. The pair of long sides and the pair of short sides of the protruding portion 1331 may each have a shape in which the height is h2 in a central portion of the side and decreases toward both ends of the side in a length direction thereof.

An edge of the coating area 133 may be separated from the edge of the component mounting area 134. As shown in FIG. 4, the coating area 133 may have an area greater than that of the component mounting area 134, and the component mounting area 134 may be provided inside the coating area 133. In some embodiments, the inner edge of the coating area 133 may be separated from the outer edge of the component mounting area 134. For example, the coating area 133 may have a gap c1 from the component mounting area 134 in the length direction of the substrate 131 (the X-axis direction) and may have a gap c2 from the component mounting area 134 in the width direction of the substrate 131 (the Y-axis direction). The gap c1 and the gap c2 may be equal to each other, or any one of the gap c1 and the gap c2 may be greater than the other. The coating area 133 may have an area greater than that of the component mounting area 134, and a gap may be formed between the coating area 133 and the component mounting area 134. The gap may function as a type of buffer area to allow the coating solution C to be stably applied onto the component mounting area 134.

In the component mounting area 134, various electrical circuits of the protection circuit module 130 may be formed, and a plurality of components 1341 may be mounted. As shown in FIG. 3, a plurality of component mounting areas 134 may be on the upper surface of the substrate 131, and each component mounting area 134 may be provided between respective ones of a plurality of substrate tabs 132 adjacent to each other. In other embodiments, some circuits and components of the protection circuit module 130 may be provided outside the component mounting area 134.

The component mounting area 134 may be an area extending along edges of the plurality of components 1341. For example, the edges of the plurality of components 1341 may be based on the component 1341 on the outermost side in the length and width directions of the substrate 131. Thus, as shown in FIG. 4, the shape of the component mounting area 134 may be a rectangle having a long side in the length direction of the substrate 131.

The protection circuit module 130 may include a plurality of component mounting areas 134 in the length direction of the substrate 131, and the at least one coating area 133 may correspond to the component mounting area 134 in a central portion of the substrate 131 in the length direction thereof. For example, one coating area 133 may be provided in the component mounting area 134 in the central portion of the substrate 131 in the length direction thereof, among the plurality of component mounting areas 134. The central portion of the substrate 131 may be vulnerable if an external force is applied to the substrate 131. Thus, by arranging the coating area 133 in the component mounting area 134 in the central portion, the rigidity of the protection circuit module 130 may be increased.

In the protection circuit module 130, by forming the protruding portion 1331 around the component mounting area 134 to define the coating area 133, the coating solution C applied to the coating area 133 may be prevented from being applied to other areas of the substrate 131. In some embodiments, the height and shape of the coating solution C may be managed uniformly. In some embodiments, by mounting the protruding portion 1331 forming the coating area 133 on the substrate 131 like a component, the coating area 133 may be easily formed. In some embodiments, the coating solution C applied to the coating area 133 may increase the strength of the component mounting area 134, thereby improving the durability of the protection circuit module 130.

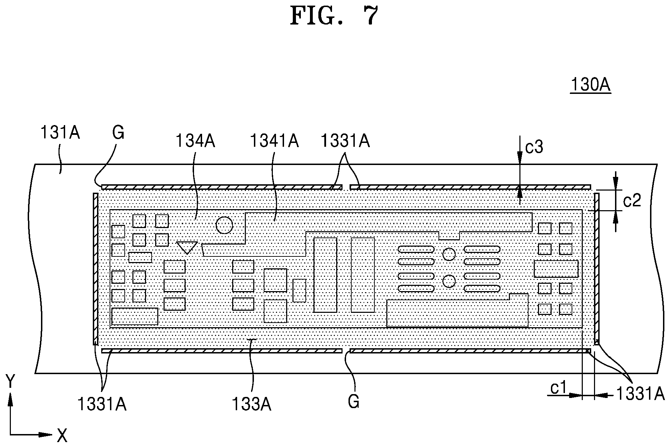

FIG. 7 shows an enlarged view of a portion of a protection circuit module 130A.

Compared to the protection circuit module 130 according to the above-described embodiments, the protection circuit module 130A according to the present embodiments may have a different configuration with respect to a protruding portion 1331A. Hereinafter, for convenience of description, the protruding portion 1331A is mainly described, and other components of the protection circuit module 130A may be the same as those of the protection circuit module 130.

Referring to FIG. 7, the protection circuit module 130A may include a substrate 131A, a coating area 133A, and a component mounting area 134A. Although not shown in the drawing, like the protection circuit module 130, the protection circuit module 130A may include two substrate tabs on the substrate 131A. In some embodiments, a plurality of components 1341A may be mounted in the component mounting area 134A.

The coating area 133A may include a plurality of protruding portions 1331A. For example, the protruding portion 1331A may be segmented into a plurality of pieces. As shown in FIG. 7, the plurality of protruding portions 1331A may be provided outside the component mounting area 134A to define the coating area 133A and may each have a bar shape. The plurality of protruding portions 1331A may be provided for each of at least one component mounting area 134A and may be separated from each other to form a plurality of gaps G.

The protruding portions 1331A may not be connected to each other and may be separated from each other by the gap G. The gap G may refer to a distance between central portions of adjacent protruding portions 1331A in a width direction thereof. Even if the gap G is present between the protruding portions 1331A, the coating solution C may not leak out through the gap G because the viscosity of the coating solution C is sufficiently high. The length of the gap G may be about 1 time to about 1.5 times the width of the protruding portion 1331A. In other embodiments, the gap G may be less than the width of the protruding portion 1331A. The plurality of protruding portions 1331A that have been segmented may be individually mounted on the substrate 131A.

Some protruding portions 1331A of the plurality of protruding portions 1331A may be provided at positions corresponding to a long side of the coating area 133A, and one protruding portion 1331A of the plurality of protruding portions 1331A may be provided at a position corresponding to a short side of the coating area 133A. As shown in FIG. 7, two protruding portions 1331A may be separated from each other by the gap G at positions corresponding to a long side of the coating area 133A, and one protruding portion 1331A may be separated from an adjacent protruding portion 1331A by the gap G at a position corresponding to a short side of the coating area 133A.

The plurality of protruding portions 1331A may each have a shape in which a central portion of the protruding portion 1331A has a greater height than both ends thereof in a length direction thereof.

A distance between the inside of a short side of the protruding portion 1331A and the component mounting area 134A may be c1, a distance between the inside of a long side of the protruding portion 1331A and the component mounting area 134A may be c2, and a distance between the outside of the long side of the protruding portion 1331A and an edge of the substrate 131A may be c3, wherein values of c1 to c3 may be the same as those of c1 to c3 of the protection circuit module 130 according to the above-described embodiments.

In the protection circuit module 130A, the protruding portion 1331A may be segmented into a plurality of pieces, rather than a single piece, so that a component mounting device, etc. may stably mount the protruding portion 1331A at an accurate position. In some embodiments, the plurality of protruding portions 1331A may be separated from each other by the gap G so that the protruding portions 1331A may not interfere with each other during mounting.

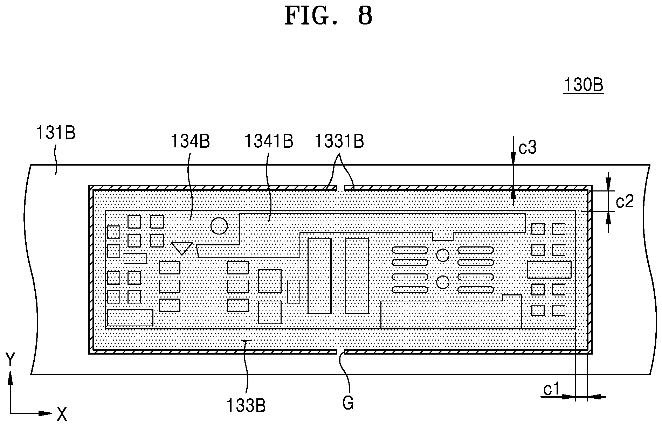

FIG. 8 shows an enlarged view of a portion of a protection circuit module 130B.

Compared to the protection circuit module 130 according to the above-described embodiments, the protection circuit module 130B according to the present embodiments may have a different configuration with respect to a protruding portion 1331B. Hereinafter, for convenience of description, the protruding portion 1331B is mainly described, and other components of the protection circuit module 130B may be the same as those of the protection circuit module 130.

Referring to FIG. 8, the protection circuit module 130B may include a substrate 131B, a coating area 133B, and a component mounting area 134B. Although not shown in the drawing, like the protection circuit module 130, the protection circuit module 130B may include two substrate tabs on the substrate 131B. In some embodiments, a plurality of components 1341B may be mounted in the component mounting area 134B.

The coating area 133B may include two protruding portions 1331B. For example, the protruding portion 1331B may be segmented into two pieces. As shown in FIG. 8, the two protruding portions 1331B may be respectively on a first side and a second side of the component mounting area 134B to define the coating area 133B. The two protruding portions 1331B may be provided for each of at least one component mounting area 134B and may be respectively on the first side and the second side of the component mounting area 134B in the length direction of the substrate 131B. The two protruding portions 1331B may each have a C-shape or a horizontally reversed C-shape to surround a portion of the component mounting area 134B. The two protruding portion 1331B may be separated from each other in the length direction of the substrate 131B to form the gap G, and the gap G may face the width direction of the substrate 131B (the Y-axis direction).

The two protruding portions 1331B may not be connected to each other and may be separated from each other by the gap G. The gap G may refer to a distance between ends of the protruding portions 1331B. Even if the gap G is present between the protruding portions 1331B, the coating solution C may not leak out through the gap G because the viscosity of the coating solution C is sufficiently high. The gap G may have a length (e.g., along the X-axis direction) that is about 1 time to about 1.5 times the width of the protruding portion 1331B. In other embodiments, the length of the gap G may be less than the width of the protruding portion 1331B. The two protruding portions 1331B may be individually mounted on the substrate 131B.

The two protruding portions 1331B may be respectively on left and right sides of the coating area 133B, and the gap G between the two protruding portions 1331B may be formed at positions corresponding to upper and lower portions of the coating area 133B. For example, the gap G may face the width direction of the substrate 131B. Thus, even if some of the coating solution C leaks out through the gap G, other components or circuits of the substrate 131B may not be contaminated.

A distance between the inside of a short side of the protruding portion 1331B and the component mounting area 134B may be c1, a distance between the inside of a long side of the protruding portion 1331B and the component mounting area 134B may be c2, and a distance between the outside of the long side of the protruding portion 1331B and an edge of the substrate 131B may be c3, wherein values of c1 to c3 may be the same as those of c1 to c3 of the protection circuit module 130 according to the above-described embodiments.

The protection circuit module 130B may include two protruding portions 1331B separated from each other. Thus, the protruding portion 1331B may be segmented into a plurality of pieces, rather than a single piece, so that a component mounting device, etc. may stably mount the protruding portion 1331B at an accurate position. In some embodiments, the two protruding portions 1331B may be separated from each other by the gap G so that the protruding portions 1331B may not interfere with each other during mounting. In some embodiments, the gap G between the two protruding portions 1331B may reduce or prevent contamination due to inevitable leakage of the coating solution C in the width direction of the substrate 131B.

FIGS. 9 to 12 show a method of manufacturing the protection circuit module 130. Although FIGS. 9 to 12 are mainly described with respect to the protection circuit module 130, the protection circuit modules 130A and 130B according to other embodiments described above may also be manufactured in the same or similar manner.

The method of manufacturing the protection circuit module 130 includes forming at least one first mounting area S1 and at least one second mounting area S2 by forming solder pads on the substrate 131, forming at least one component mounting area 134 by mounting a plurality of components 1341 in the at least one first mounting area S1, forming at least one coating area 133 by mounting at least one protruding portion 1331 in the at least one second mounting area S2, and applying the coating solution C to the at least one coating area 133.

First, as shown in FIG. 9, solder pads may be formed on the substrate 131 to form at least one first mounting area S1 and at least one second mounting area S2. The at least one first mounting area S1 may be formed on the substrate 131 to have a shape and size corresponding to that of the component mounting area 134 or to have a size greater than that of the component mounting area 134. In some embodiments, the at least one second mounting area S2 may be formed on the substrate 131 to have a shape and size corresponding to that of the protruding portion 1331 defining the coating area 133 or to have a size (a width) greater than that of the protruding portion 1331.

The forming of the at least one first mounting area S1 and the at least one second mounting area S2 may include forming the solder pads on the substrate 131 such that at least one second mounting area S2 may surround the at least one first mounting area S1. In some embodiments, an inner edge of the second mounting area S2 may be formed to be separated from an outer edge of the first mounting area S1.

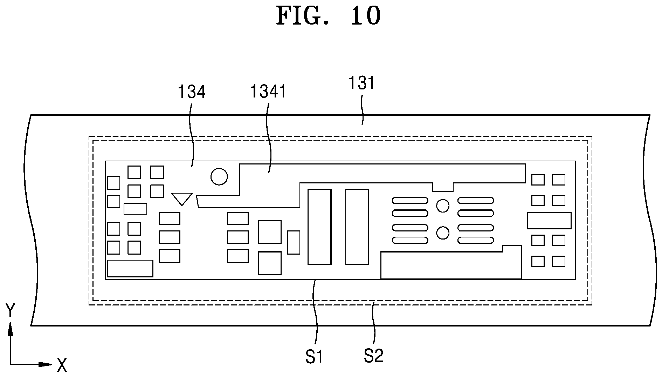

Then, as shown in FIG. 10, the component(s) 1341 are mounted in the first mounting area S1. A method of mounting the component(s) 1341 may be a known component mounting method using a component mounting device, etc. The component(s) 1341 may be mounted by supporting the component(s) 1341 by a suction or mechanical method, moving the component(s) 1341 to the first mounting area S1 where the solder pad is formed, and then placing the component(s) 1341 down. The component mounting area 134 may be formed along an outer edge of the mounted component(s) 1341.

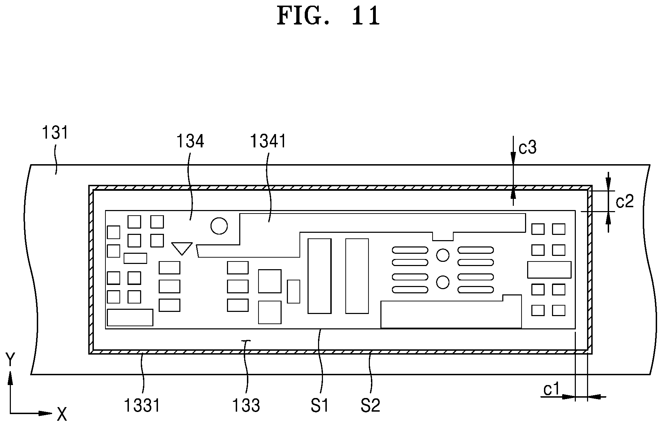

Then, as shown in FIG. 11, the protruding portion 1331 is mounted in the second mounting area S2 to form the coating area 133. A method of mounting the protruding portion 1331 may be performed in the same manner as the method of mounting the component(s) 1341. In some embodiments, the protruding portion 1331 may include a single piece, and a component mounting device may support the one protruding portion 1331 and mount the one protruding portion 1331 in one second mounting area S2. The coating area 133 may be formed along an inner edge of the mounted protruding portion 1331. A distance between the inside of a short side of the protruding portion 1331 and the component mounting area 134 may be c1, a distance between the inside of a long side of the protruding portion 1331 and the component mounting area 134 may be c2, and a distance between the outside of the long side of the protruding portion 1331 and an edge of the substrate 131 may be c3.

The forming of the at least one coating area 133 may include mounting one protruding portion 1331 including a single piece in each of the at least one second mounting area S2. In other embodiments, a plurality of protruding portions 1331A and 1331B may be mounted in each of the at least one second mounting area S2 such that a gap is formed therebetween.

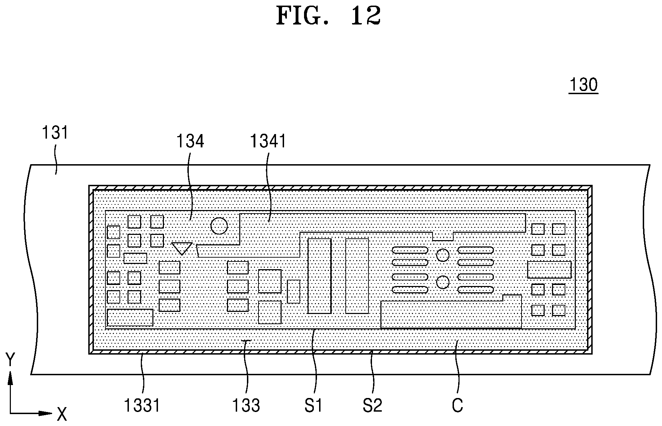

Then, as shown in FIG. 12, the coating solution C is applied to the coating area 133. The applied coating solution C may not overflow to the outside of the coating area 133 and may be maintained inside the coating area 133 by the protruding portion 1331. The maximum height of the coating solution C may be the same as that of the protruding portion 1331 or may be greater than that of the protruding portion 1331 due to the viscosity of the coating solution C.

In a battery pack and a method of manufacturing the same, according to embodiments of the present disclosure, a coating solution applied to a component mounting area of a protection circuit module may be formed to a desired height and shape.

In the battery pack and the method of manufacturing the same, according to embodiments of the present disclosure, by preventing a coating solution from flowing into areas other than a component mounting area of a substrate, the other areas of the substrate may be prevented from being contaminated.

In the battery pack and the method of manufacturing the same, according to embodiments of the present disclosure, by preventing a tab connecting a battery cell and a protection circuit module to each other from being contaminated by a coating solution, the battery cell and the protection circuit module may be properly coupled to each other without contamination.

In the battery pack and the method of manufacturing the same, according to embodiments of the present disclosure, by forming a coating area through a fixing frame arranged around a component mounting area to include the component mounting area, the height and shape of a coating solution may be managed.

In the battery pack and the method of manufacturing the same, according to embodiments of the present disclosure, a fixing frame may be simply and easily mounted on a substrate.

According to some embodiments, there is provided a protection circuit module configured to be connected to a battery cell, the protection circuit module comprising: a substrate; at least one component mounting area on the substrate and comprising a plurality of components; and at least one coating area on the substrate at least in part corresponding to the at least one component mounting area and comprising at least one protruding portion supporting a coating solution within the at least one coating area, and at least a portion of the at least one protruding portion comprises a same material as that of the substrate and is mounted on the substrate.

In some embodiments, the substrate may include at least one first mounting area corresponding to the at least one component mounting area and having a solder pad formed thereon; and at least one second mounting area corresponding to the at least one coating area and having a solder pad formed thereon.

In some embodiments, each of the at least one coating area may include a single protruding portion comprising a single piece.

In some embodiments, the single protruding portion may be provided outside each of the at least one coating area and may have a closed contour.

In some embodiments, an inner edge of the single protruding portion may be separated from an edge of each of the at least one coating area, and an outer edge of the single protruding portion may be separated from an edge of the substrate.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of the present disclosure as defined by the following claims.

## Claims

1. A battery pack comprising:
a case;
a battery cell accommodated in the case; and
a protection circuit module connected to the battery cell, wherein the protection circuit module comprises:
a substrate;
at least one component mounting area on the substrate and comprising a plurality of components; and
at least one coating area on the substrate at least in part corresponding to the at least one component mounting area and comprising at least one protruding portion supporting a coating solution within the at least one coating area, and
at least a portion of the at least one protruding portion comprises a same material as that of the substrate and is mounted on the substrate.

2. The battery pack as claimed in claim 1, wherein the substrate comprises:
at least one first mounting area corresponding to the at least one component mounting area and having a solder pad formed thereon; and
at least one second mounting area corresponding to the at least one coating area and having a solder pad formed thereon.

3. The battery pack as claimed in claim 1 or claim 2, wherein each of the at least one coating area comprises a single protruding portion comprising a single piece.

4. The battery pack as claimed in claim 3, wherein:
(i) the single protruding portion is provided outside each of the at least one coating area and has a closed contour; and/or
(ii) an inner edge of the single protruding portion is separated from an edge of each of the at least one coating area, and an outer edge of the single protruding portion is separated from an edge of the substrate.

5. The battery pack as claimed in any one of claims 1 to 4, wherein the at least one protruding portion has a constant height.

6. The battery pack as claimed in any one of claims 1 to 3, wherein a height of the at least one protruding portion gradually increases toward a central portion of the at least one protruding portion in a length direction thereof.

7. The battery pack as claimed in claim 1 or claim 2, wherein the at least one protruding portion comprises a plurality of protruding portions provided for each of the at least one component mounting area, the plurality of protruding portions being separated from each other to form a plurality of gaps, optionally wherein:
(i) the plurality of protruding portions comprises two protruding portions provided for each of the at least one component mounting area, respective ones of the two protruding portions being disposed on a respective one of a first side and a second side of the at least one component mounting area in a length direction of the substrate, and a gap between the two protruding portions faces a width direction of the substrate; and/or
(ii) some protruding portions of the plurality of protruding portions are provided to be separated from each other and correspond to a long side of the at least one component mounting area, and
one protruding portion of the plurality of protruding portions is provided to correspond to a short side of the at least one component mounting area.

8. The battery pack as claimed in any one of claims 1 to 7, wherein the at least one component mounting area comprises a plurality of component mounting areas disposed along a length direction of the substrate, and
the at least one coating area corresponds to a component mounting area of the plurality of component mounting areas disposed in a central portion of the substrate in the length direction thereof.

9. A method of manufacturing a battery pack, the method comprising:
forming at least one first mounting area and at least one second mounting area by forming solder pads on a substrate;
forming at least one component mounting area by mounting a plurality of components in the at least one first mounting area;
forming at least one coating area by mounting at least one protruding portion in the at least one second mounting area; and
applying a coating solution to the at least one coating area.

10. The method as claimed in claim 9, wherein the forming of the at least one first mounting area and the at least one second mounting area comprises forming the solder pads on the substrate such that the at least one second mounting area surrounds the at least one first mounting area.

11. The method as claimed in claim 9 or claim 10, wherein the forming of the at least one coating area comprises mounting a single protruding portion comprising a single piece in each of the at least one second mounting area.

12. The method as claimed in claim 9 or claim 10, wherein the forming of the at least one coating area comprises mounting a plurality of protruding portions in each of the at least one second mounting area such that a respective gap is formed between respective ones of the plurality of protruding portions.

13. A protection circuit module configured to be connected to a battery cell, the protection circuit module comprising:
a substrate;
at least one component mounting area on the substrate and comprising a plurality of components; and
at least one coating area on the substrate at least in part corresponding to the at least one component mounting area and comprising at least one protruding portion supporting a coating solution within the at least one coating area, and
at least a portion of the at least one protruding portion comprises a same material as that of the substrate and is mounted on the substrate.

14. The protection circuit module as claimed in claim 13, wherein the substrate comprises:
at least one first mounting area corresponding to the at least one component mounting area and having a solder pad formed thereon; and
at least one second mounting area corresponding to the at least one coating area and having a solder pad formed thereon.

15. The protection circuit module as claimed in claim 13 or claim 14, wherein each of the at least one coating area comprises a single protruding portion comprising a single piece, optionally wherein:
(i) the single protruding portion is provided outside each of the at least one coating area and has a closed contour; and/or
(ii) an inner edge of the single protruding portion is separated from an edge of each of the at least one coating area, and
an outer edge of the single protruding portion is separated from an edge of the substrate.
